# EUROPEAN PATENT SPECIFICATION

(11) **EP 2 347 031 B1**
(45) Date of publication and mention of the grant of the patent: **14.03.2018**
(21) Application number: 09748280.6
(22) Date of filing: 20.10.2009
(51) Int. Cl.: C23C 16/458, C23C 16/455, C23C 16/44

(54) **ATOMIC LAYER DEPOSITION POWDER COATING**
ATOMLAGENABSCHEIDUNGSPULVERBESCHICHTUNG
REVÊTEMENT DE POUDRE PAR DÉPÔT EN COUCHE ATOMIQUE

(30) Priority: 20.10.2008 GB 0819183
(43) Date of publication of application: 27.07.2011
(73) Proprietor: Universiteit Gent, 9000 Gent (BE)
(72) Inventor: DETAVERNIER, Christophe, 9473 Denderleeuw (BE); HAEMERS, Johan, 9051 Sint-Denijs-Westrem (BE); DEDUYTSCHE, Davy, 9840 De Pinte (BE)
(74) Representative: Wauters, Davy Erik Angelo
(86) International application number: PCT/EP2009/063758
(87) International publication number: WO 2010/046373

(56) References cited:
- US-A- 3 944 053
- US-A- 6 060 129
- US-B1- 6 251 337
- US-B2- 6 913 827
- MCCORMICK J ET AL: "Rotary reactor for atomic layer deposition on large quantities of nanoparticles", JOURNAL OF VACUUM SCIENCE AND TECHNOLOGY: PART A, AVS /AIP, MELVILLE, NY., US, vol. 25, no. 1, 2 January 2007 (2007-01-02), pages 67-74, XP012102560, ISSN: 0734-2101, DOI: DOI:10.1116/1.2393299 cited in the application

## Description

### Technical field of the invention

The present invention relates to methods and systems for coating small objects such as for example particles, powders or granular materials. More particularly, the present invention relates to methods and systems for coating such objects using atomic layer deposition.

### Background of the invention

Modification of the surface of particles, powders or granular materials often is performed for changing the chemical or physical characteristics of these objects or their surface. A large number of applications are known, such as improvement of wear and/or corrosion resistance of metallic objects and particles, catalytic activation of powders, controlling adhesion forces between particles, controlling the adsorption of water for small objects, etc. An often used surface modification technique is coating of the surface, thus allowing engineering of the surface properties of the objects. Another application involving coating of particles is the formation of core/shell structures or hollow structures. Core/shell structures can be created by coating of materials on particles and hollow structures can be obtained by removal, once the core/shell structures are obtained, of the core, for example by thermal decomposition at high temperature. The latter results in formation of hollow structures that are replicas of the original morphology of the particles. In this way, for example tubes or hollow spheres can be obtained.

The thickness and uniformity of the coating provided on the particles may be an important parameter influencing the properties of the object. It therefore is advantageous to have methods and systems allowing conformal coating. Nevertheless, despite the clear technological relevance, only few techniques have been explored for conformal coating of particles.

Some suggestions for solutions include deposition on a pile of powder that is stationary during the deposition. Nevertheless, it has been shown experimentally that conformal growth for all particles in the pile is impossible due to the small flux of precursors that reach the particles at the inner side of the pile. For example in atomic layer deposition, where conformal growth is expected as the deposition is controlled by self-limited adsorption reactions, it was shown that typically only the particles at the outer layers of particles of the pile are coated, even when reasonably long pulse and pump times (up to minutes) are used.

Other solutions are based on a fluidized bed approach. In such a fluidized bed approach a gas flow is used to 'levitate' the particles. While this approach to powder ALD has been reported in literature, there are several disadvantages. Firstly, in order to maintain fluidization, a high gas throughput is required. Using, often expensive, precursor gas for this fluidization is not advantageous. Attempts were made to partially decouple the fluidization from the gas flow, by applying mechanical agitation. Mechanical stirring and/or the application of mechanical vibration allowed for fluidization at a pressure between 1-10 Torr. Given the restrictions on gas flow and pressure, the fluidized bed approach is not compatible with the concept of plasma enhanced ALD. Secondly, the fluidized bed solution is limited to fine powders, and cannot be used for e.g. granulates or small objects.

In "Rotary Reactor for Atomic Layer Deposition on large Quantities of Nanoparticles", J. Vacuum Science and Technology A 25 (2007), McCormick et al. describes a rotary unit for ALD coating of nanoparticles.

The document describes a system comprising a rotating cylinder made of porous metal which is placed within a stainless steel vacuum vessel wherein nanoparticles are positioned. The porous metal cylinder is rotated by means of a ferrofluidic rotary feedtrough. A schematic representation of such a system is shown in FIG. 1, indicating a porous metal cylinder 10, rotatable within a tube 20. US 6060129 describes a deposition system for plasma enhanced coating of a plurality of three dimensional objects. There is a need for a system with practical design for performing atomic layer deposition powder coating of small particles.

### Summary of the invention

It is an object of embodiments of the present invention to provide good methods and systems for conformal coating of particles. It is an advantage of embodiments according to the present invention that accurate conformal coating of particles can be performed, with limited use of precursor materials.

The above objective is accomplished by a method and device according to the present invention. The present invention relates to an atomic layer deposition system for providing a coating or treatment to a plurality of three dimensional objects simultaneously, the atomic layer deposition system being a plasma enhanced atomic layer deposition system comprising a dielectric tube adapted for containing the plurality of objects under vacuum, at least one inlet for providing a gaseous material in the dielectric tube, an RF radiation generator adjacent the dielectric tue that enables plasma enhanced deposition or treatment of the plurality of objects, wherein the system comprises a rotation mechanism for rotating the dielectric tube which is rotatably mounted so as to be able to rotate the plurality of objects under vacuum during atomic layer deposition for providing a coating or treatment on the plurality of objects. The system comprising a second dielectric tube contained within and fixed to the rotatable dielectric tube containing the plurality of objects, and mechanical indentations in the dielectric tube that cause the plurality of objects to tumble and to be maintained within a reaction area for at least a predetermined amount of time that are furthermore positioned downstream a region of plasma generation, but adjacent thereto.

The plurality of three dimensional objects may be a plurality of small objects. It may for example be a powder, particles or granular material, the invention not being limited thereto. It is an advantage of embodiments according to the present invention that conformal coating of these three dimensional objects can be obtained at all outer surfaces of the objects. The dielectric tube being an outer dielectric tube may mean that outside the dielectric tube standard atmospheric pressure is present. It is an advantage of embodiments according to the present invention that a full separation between movement of the objects and the deposition can be obtained by providing mechanical agitation of the objects while using gas flows for the deposition.

The system may comprise a controller for controlling the inlet of different gaseous materials in sequence.

The system furthermore comprises an RF radiation generating means adjacent the dielectric tube for allowing RF plasma enhanced coating or treating of the plurality of objects. It is an advantage of embodiments according to the present invention that plasma can be induced thus allowing plasma enhanced deposition techniques.

A tube furnace may be provided around the rotatable dielectric tube. It is an advantage of embodiments according to the present invention that accurate control of temperature can be obtained in the ALD system. It is an advantage of embodiments according to the present invention that an ALD reaction area can be generated within or downstream the plasma region, thus allowing efficient plasma enhanced deposition techniques.

The system may comprise a vacuum sealing means for allowing maintenance of a vacuum of 10⁻⁵ mbar, advantageously at least 5.10⁻⁶ mbar, more advantageously 2.10⁻⁶ mbar at a rotation speed of the dielectric tube of at least 1 rpm, advantageously at least 20 rpm, more advantageously at least 50 rpm. It is an advantage of embodiments according to the present invention that good vacuum can be maintained for rotation speeds sufficiently high to rotate the plurality of objects to bring each side of the objects in contact with the precursors.

The system may comprise a static metal flange and a rotatable metal tube, wherein the vacuum sealing means may comprise a first seal for providing a vacuum sealing between the rotatable dielectric tube and the rotatable metal tube, and a second seal for providing an oil-based sealing between the rotatable metal tube and the static metal flange. A vacuum sealing means may be provided at each side of the rotatable dielectric tube. It is an advantage of embodiments according to the present invention that a vacuum tight system can be obtained wherein a dielectric tube is rotatable, thus allowing e.g. RF plasma enhanced treatments.

The tube may comprise mechanical indentations so as to make the plurality of objects tumble and maintain them within a reaction area of the dielectric tube for at least a predetermined amount of time. It is an advantage of embodiments according to the present invention that the plurality of objects to be coated can maintained in the reaction area based on mechanical obstructions and not based or not solely based on centrifugal forces, thus allowing the system to operate at relatively small rotation frequency. The latter assists in maintaining good vacuum conditions.

The system may comprise a feeding means for providing a continuous feed of objects to be coated or treated. It is an advantage of embodiments according to the present invention that the system can be easily upscaled, thus allowing coating for large quantities of objects.

The feeding means for providing a continuous feed of objects may comprise mechanical indentations in the dielectric tube for propagating the plurality of objects through the dielectric tube upon rotation. It is an advantage of embodiments according to the present invention that a relatively easy implementation of a continuous feed system can be provided.

The at least one inlet for providing a precursor material may be connected to a vessel containing the precursor.

The at least one inlet for providing a gaseous material may consist of one entrance point for gaseous material to enter the tube, per type of gaseous material. It is an advantage of embodiments of the present invention that the number of entrance points for gaseous material entering the tube can be limited so as to be able to limit the pumping time. It is an advantage of some embodiments that complex showerheads allowing quick uniform distribution of the gas and comprising a plurality of entrance points can be avoided. The latter is especially possible as ALD is a technique based on self-limiting adsorption reactions.

The present invention also relates to a method for conformal coating or treating of a plurality of three dimensional objects simultaneously, the method comprising providing a plurality of three dimensional objects simultaneously in a dielectric tube under vacuum rotating the dielectric tube so as to rotate the plurality of three dimensional objects, and providing, during said rotating, precursor materials so as to coat or treat the plurality of objects using atomic layer deposition.

The method further comprises providing RF radiation in the dielectric tube so as to induce plasma enhanced atomic layer deposition. Said providing objects is providing the objects being contained in a second dielectric tube, the electric tube being fixed two the first dielectric tube. The method also comprises causing the plurality of objects to tumble using mechanical indentations and maintaining the plurality of objects within a reaction area for at least a predetermined amount of time that are furthermore positioned downstream a region of plasma generation, but adjacent thereto.

The method may comprise maintaining the plurality of objects in a reaction region of the dielectric tube using mechanical blocking components.

The method further may comprise propagating the plurality of objects through the dielectric tube at a predetermined speed so as to allow continuous feeding of objects.

A three dimensional object is also described, the three dimensional object being treated or coated using a method for conformal coating as described above and/or using atomic layer deposition in a system as described above.

It is an advantage of embodiments according to the present invention that the atomic layer deposition technique can be performed in a plasma enhanced way.

### Brief description of the drawings

FIG. 1 - prior art, is a schematic illustration of an ALD processing system for powder coating comprising a stainless steel vacuum chamber, containing a closed metallic cylinder with porous walls for holding the powder. The porous cylinder is rotated within the vacuum chamber by means of a ferrofluidic rotary feedthrough, as known from prior art.
FIG. 2 is a schematic illustration of an ALD system for powder coating according to an embodiment of the present invention.
FIG. 3 is a schematic illustration of an example of an ALD system for powder coating according to a first embodiment of the present invention.
FIG. 4 is a schematic illustration of a sealing means of an exemplary ALD system according to an embodiment of the present invention.
FIG. 5 is a schematic illustration of an exemplary ALD system adapted for plasma enhanced ALD, according to an embodiment of the present invention.
FIG. 6 is a schematic illustration of a propagation means in a tube that can be used in an atomic layer deposition system allowing continuous feed of material, according to an embodiment of the present invention.
FIG. 7 to FIG. 11 illustrate different EDX spectra indicative of deposition of aluminium oxide on particles, according to examples of embodiments of the present invention.
FIG. 12 to FIG. 13 illustrate different EDX spectra of the inner side and outer side of a filament, coated using embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. Any reference signs in the claims shall not be construed as limiting the scope. The drawings described are only schematic and are non-limiting. In the drawings, the size of some of the elements may be exaggerated and not drawn on scale for illustrative purposes.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with independent claims 1 and 9 defining the atomic layer deposition system and coating method according to the invention, respectively, and dependent claims 2-8 and 10 concerning particular embodiments thereof. Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect, the present invention relates to a system for simultaneous conformal coating of a plurality of three dimensional objects. Such three dimensional objects may be small objects. The objects may for example be particles, powder or granulate material, although the invention is not limited thereto. The objects can have a smooth surface or can be porous, such as for example zeolites. The system is adapted for performing atomic layer deposition (ALD) for creating the conformal treating or coating. It is an advantage of embodiments according to the present invention that the technique allows providing a coating with uniform thickness. The system may be especially suitable for surface modification of small objects in bulk.

According to embodiments of the present invention, the system comprises a dielectric tube adapted for containing the plurality of objects. The dielectric tube may be made of any suitable dielectric material, such as for example quartz, glass or alumina. Advantageously, the material used is adapted for being resistant to sufficiently high temperatures, so as to allow the necessary chemical and/or adsorption reactions for performing the atomic layer deposition process. The dielectric tube is mounted in a rotatable way, so as to be able to rotate the plurality of objects within the tube, during atomic layer deposition. The rotation speed may be of the order of at least 1rpm, for example between 1 rpm and 500 rpm or between 10 rpm and 200 rpm. The latter induces mechanical agitation of objects contained in the tube, thus allowing exposing all surface areas of the objects to gas ambients created. It is an advantage of embodiments according to the present invention that the mechanical agitation provided by the rotary motion allows precursor gas to adsorb onto the entire surface of all objects, thus allowing to provide a conformal and uniform coating on the objects. The latter is obtained by providing a rotary motion of the tube in which the objects may be contained, resulting in continuous tumbling of the objects and exposing the entire surface to the gas ambient. It is also an advantage of embodiments according to the present invention that agitation of the particles and gas flow or gas pressure can be decoupled completely, by using mechanical agitation by rotation. The latter allows optimization of use of precursor gasses, which often are expensive. Furthermore, as no gas flow or pressure is used for the agitation, it provides the option to work in substantially stationary regime. The latter is also advantageous to reduce pulse and pump cycles, especially when treating objects having large surface areas and small pores or where objects are staggered so that only small spacings are available between them.

According to embodiments of the present invention, the system may be adapted for maintaining a vacuum or predetermined gas pressure level in the tube during the deposition. The system may be adapted for maintaining a vacuum may be of the order of at least 10⁻² mbar, advantageously at least 10⁻⁴ mbar, more advantageously at least 5.10⁻⁶ mbar and still more advantageously at least 2.10⁻⁶ mbar. The system furthermore advantageously is adapted to maintain such a vacuum or predetermined gas pressure level at rotation speeds as described above.

According to embodiments of the present invention, the system furthermore comprises at least one inlet for providing a gaseous material in the dielectric tube. Separate inlets for each of the precursor materials and/or reaction gasses may advantageously be provided. It is an advantage of embodiments according to the present invention that an inlet with a single entrance point in the tube may be provided, for each of the different gaseous materials to be provided. It thereby is an advantage that no complex showerhead is to be provided to have a quick uniform distribution of the material as for ALD the reactions of the gaseous materials are self limiting. The latter is advantageous as it reduces pump time for removing gaseous material after each step.

The above system allows for performing atomic layer deposition as a coating or treating technique for coating or treating the plurality of objects. The system thus is adapted for performing atomic layer deposition. Atomic layer deposition is a deposition technique for providing a conformal coating on objects, based on self-limited adsorption reactions. The type of self-limited adsorption reactions that can be performed, determined by the chemical interactions between the objects to be treated and the gaseous materials such as precursor(s) and reaction gas(ses) used, are not limiting the system or method according to embodiments of the present invention. In other words, the system or method is not determined by the reactions or gaseous materials to be used in the atomic layer deposition process. Some examples of coatings that can be applied to objects, only provided for the sake of illustration and thus not limiting embodiments of the invention, are atomic layer deposition of Al₂O₃, TiO₂, TiN, Ru, AlN, TaN and V₂O₅. The ALD reactions may be performed for a wide range of materials, such as for example for metals, oxides, nitrides, sulfides, tellurides, etc. In one example deposition of Al₂O₃ on silicon was performed leading to conformal deposition.

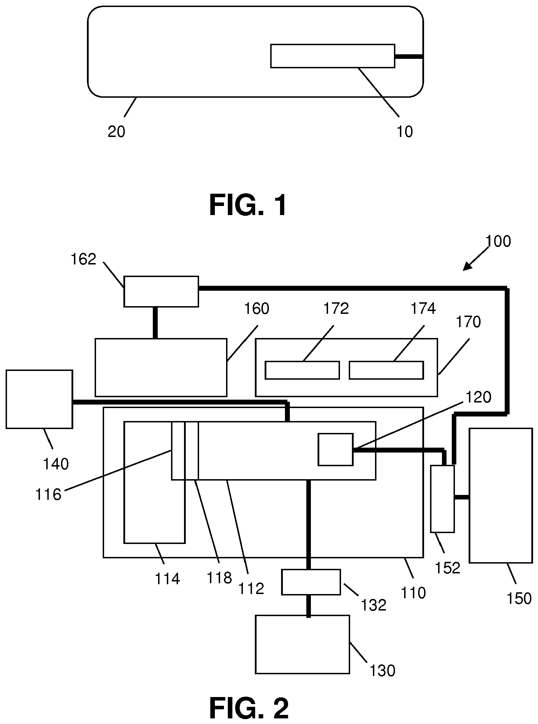

By way of illustration, the present invention not being limited thereto, a more detailed description of these and other, optional components of the system are described with reference to FIG. 2, indicating a schematic overview of standard and optional components of the system.

The atomic layer deposition system 100 may comprise a reaction unit 110 wherein the atomic layer deposition may be performed, and a number of additional components, outside the reaction unit 110 assisting in the operation of the atomic layer deposition.

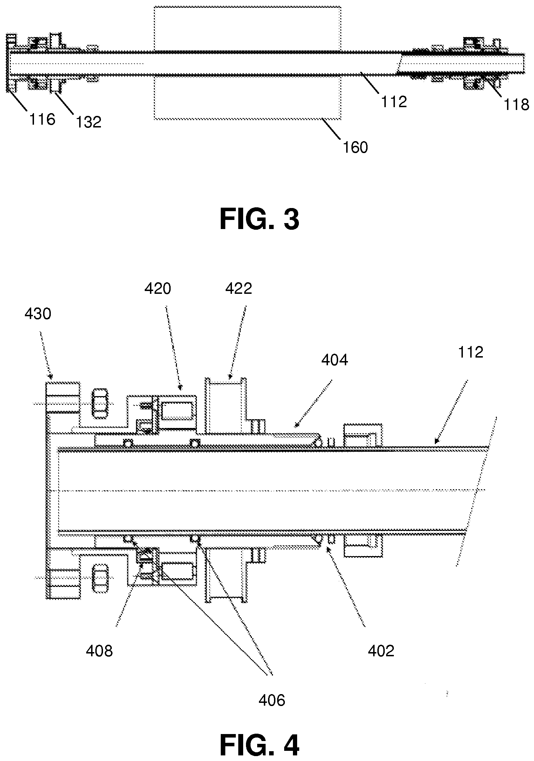

The reaction unit 110 comprises a rotatable dielectric tube 112, wherein the objects to be treated or coated are positioned and wherein the reaction will take place. The rotatable dielectric tube 112 may have the features and advantages as described above. The rotatable dielectric tube 112 may be supported by a support 114, advantageously providing support at each side of the rotatable dielectric tube 112. The support 114 typically may be static with respect to the environment. The reaction unit furthermore comprises a coupling means 116 for coupling the rotatable dielectric tube 112 to the static support 114. The coupling means 116 may comprise or consist of a sealing means 118, for sealing the rotatable dielectric tube in a substantially vacuum tight manner with respect to the environment. A particular example of a coupling means and a sealing means, the present invention not being limited thereto, will be described further with respect to FIG. 4.

The reaction unit 110 furthermore comprises at least one gas inlet 120 for providing gaseous material like a precursor or reaction gas in the dielectric tube.

Advantageously, a gas inlet 120 is provided for each type of precursor and/or reaction gas to be provided in the dielectric tube. For atomic layer deposition, it is advantageous that the number of entrance points per type of precursor or reaction gas to be introduced is limited, preferably equals one. The latter is advantageous as it reduces the number of inlet portions to be pumped, when a switch to a different reactor gas or precursor is to be made. Furthermore, as the reaction is self-limited the position of the inlet with respect to the objects is less an issue.

The powder may be loaded in different ways, such as for example by using an inner dielectric tube which is coupled to the rotatable dielectric tube 112, the inner dielectric tube thus also becoming a rotatable dielectric tube, using a continuous feeding system, etc. Where in the present application reference is made to the rotating dielectric tube 112, reference may be made to an outer dielectric tube as well as to an inner dielectric tube.

The rotatable dielectric tube 112 may be rotated using a motor 130. The motor may be any type of motor allowing to obtain a suitable rotation speed. It may for example be an electric motor. The motor may be equipped with a transferring means 132 for transferring the movement of the motor into a rotating movement of the dielectric tube. Such transferring means 132 may for example be a drive wheel, transferring the movement of an axis of the motor to a belt, a further drive wheel transferring the movement of the belt to the further drive wheel and ball bearings, being coupled to the further drive wheel transferring the movement to the dielectric tube 112 and ensuring easy rotation of the dielectric tube. The ball bearings may for example be self-aligning. By way of illustration, such ball bearings 420 and such a further drive wheel 422 are indicated in the example of FIG. 4. In order to control the position of the objects in the reaction region of the rotatable dielectric tube 112, indentations may be provided for maintaining the objects within the reaction region. In combination with rotation of the dielectric tube 112, the indentations ensure that the particles are continuously intermixed, even at low rotation speeds. The mixing thereby is based on tumbling of the objects.

It is an advantage of embodiments according to the present invention that the objects to be treated or coated can be kept continuously in motion, thus allowing easier acces of the precursor gasses to the surfaces of the objects. It further is an advantage of embodiments according to the present invention that continuous motion may also prevent agglomeration of objects during the treating or coating process.

It is an advantage of such embodiments that the systems and methods for distributing particles within the tube during deposition are practical, as they can be performed at low rotation speeds, nor relying exclusively on centrifugal force, and as they offer the potential for upscaling to a continuous feed of objects.

The dielectric tube 112, may be evacuated by a pumping means 140. Such a pumping means 140 may comprise a roughing and/or high vacuum pump, depending on the vacuum required. In one embodiment, the pumping means 140 may combine a rotation and a turbomolecular pump.

Each of the at least one gas inlet may be connected with a gaseous material reservoir 150, such as e.g. a precursor reservoir or a reaction gas reservoir. Introduction of precursors or reaction gas may be performed in a controllable way, for example using gas inlet control means 152. It is an advantage of embodiments according to the present invention that the system may be adapted with a controller for providing different gaseous materials in sequence. The gas inlet control means 152 may comprise for example mass flow controllers and/or needle valves and/or computer controlled pneumatic shut-off valves, the invention not being limited thereto, to control the amount of gaseous material and/or the timing. In one embodiment, to optimize the use of expensive precursor gas, one could work in a stationary gas regime, whereby the dielectric tube 112 is connected to the precursor reservoir 150 containing for example the precursor in a liquid form and being such that the pressure in the dielectric tube 112 equals the vapor pressure of the precursor. To prevent condensation in such a setup, the precursor liquid either may be cooled below room temperature (provided it can still generate enough vapor pressure), or the entire system of gas lines and chamber may be heated significantly higher than the precursor reservoir to avoid condensation.

After a certain 'pulse' or exposure time, the remaining vapor gas is pumped from the chamber, and the chamber can be filled with a further precursor or reacting gas (e.g. water vapor or oxygen). Since there is no gas flow during the pulse (static exposure), the (often expensive) precursor gas will be used efficiently in such an embodiment.

The system 100 furthermore may comprise a furnace 160, in order to bring the reaction region at the appropriate temperature for the reaction to occur. The furnace 160 may be controlled using a temperature control means 162, which may be a programmable temperature controller, optionally in communication with the gas inlet control means 152. The furnace 160 may for example be a tube furnace, positioned around the tube 112, at the reaction region of the tube 112. It is an advantage of embodiments according to the present invention that a tube furnace can be used, allowing for accurate control of the deposition temperature within a wide range.

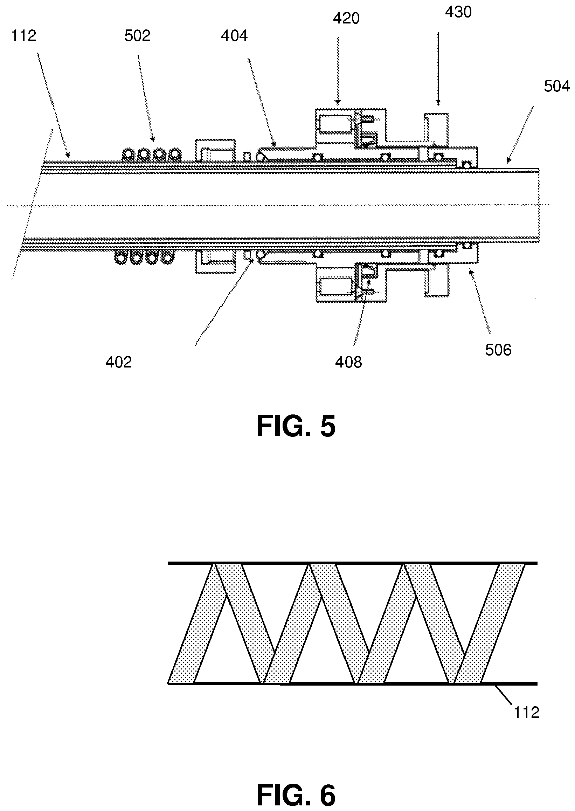

The system 100 furthermore may comprise an RF signal generating means 170, for inducing RF radiation in the reaction region. The latter may for example be used for obtaining plasma enhanced deposition, as will be described later in particular embodiment with reference to FIG. 5. The RF signal generating means 170 may comprise an RF coil 172 and a power supply and matching unit 174 allowing to obtain such signals.

Part of the reaction unit is schematically also shown in FIG. 3, indicating the rotatable dielectric tube 112, the coupling means 116 and the sealing means 114. Furthermore a furnace 160 and part of the transferring means 132 are shown.

For ALD, there is often a minimum reaction temperature to enable the surface reaction, hence a furnace 160 around the dielectric tube can advantageously be used. The region inside this furnace is the deposition zone or reaction zone. For certain precursors, it may also be necessary to heat up all other sections of the reactor outside this reaction zone in order to avoid condensation of the precursor vapour (especially for the above case of 'static mode'). This would give rise to three temperature controls : one for the bubbler (to create precursor vapour) at a first temperature, one to maintain all parts of the reactor outside the reaction zone slightly above the first temperature (to avoid condensation), and one for the reaction zone itself (determined by the minimum temperature required by the surface reaction).

It is an advantage of embodiments according to the present invention that the system is flexible and can be easily combined with other processing chambers and other techniques. Consequently, whereas some of the above components may be provided in the system, the present invention is not limited thereto and some components may be used in common with other systems, such as for example other coating systems. Some examples of components that may be used in common are the pumping system, a power supply for an RF unit (as will be dicussed further), the precursor and gas handling system, etc.

In one embodiment, although the system is adapted for atomic layer deposition (ALD) processes, the gas handling and pumping may be adjustable to allow chemical vapor deposition (CVD) as a coating technique in the atomic layer deposition.

By way of illustration, the present invention will be further described with reference to a number of particular embodiments, the present invention not being limited thereto.

In one particular embodiment, the present invention relates to a system as described above, wherein the sealing means for providing a substantially vacuum tight rotary tube comprises a double sealing. The double seal may be provided to obtain a first seal between the dielectric tube and a rotatable metal part, moving at the same rotation speed, and a second seal between the rotatable metal part and a static metal part. The latter allows providing a seal between a static and rotatable component as a seal between two metal parts, allowing an easier vacuum tight sealing than a sealing between a static metal part and a rotatable dielectric part. By way of illustration, an example of such a double sealing is illustrated in FIG. 4. It is to be noticed that, whereas sealing at only one side of the rotary unit is described and shown with respect to FIG. 4, advantageously, at each side of the rotatable dielectric tube 112 a sealing means is provided. On one or both sides of the tube, the sealing means may comprise two vacuum seals. A first seal 402 may seal the rotatable dielectric tube 112 with respect to a metal part 404. This sealing may be provided as an elastic sealing such as for example an o-ring. Advantageously, the elastic seal may be provided in a groove in the metal part. Such a groove advantageously may make an angle of substantially 45° with the surface of the dielectric tube 112, so that the compressive force is translated into a clamping force of the elastic seal onto the dielectric tube 112. The latter may assist in causing a vacuum tight connection. The tube 112 and the metal part 404 advantageously rotate simultaneously, so that no other forces act on the elastic seal. Furthermore, additional O-rings 406 for guiding the quartz tube throught the metal part also may be provided. A second seal 406 between the rotating metal part and a static metal part, e.g. a stationary metal flange may for example be established by an oil-seal. Such an oil seal may for example be an oil seal as used in engines. The second seal 408 may be positioned inside a groove of the fixed metal part. The fixed metal part may be a vacuum flange 430. The groove may be filled with vacuum grease to ensure proper sealing. Using a double seal as described above at each side of the dielectric tube, vacuum levels of 10⁻⁶ mbar have been obtained while rotating the tube at a speed of about 100rpm. It is an advantage of these embodiments that the sealing means for sealing the rotatable tube are practical and economical. They furthermore offer the potential for upscaling to larger quantities of material.

In another particular embodiment, the present invention relates to a system as described in any of the above embodiments, wherein furthermore a means for generating RF radiation in the dielectric tube is provided. The means for generating RF radiation may for example be an inductor coil wound around the dielectric tube, although the invention is not limited thereto. Alternatively, the means for generating RF radiation may comprise a set of planar electrodes, mounted inside the vacuum chamber. The latter may be less advantageous as it results in a more complicated design and decreased reliability of the system as electrodes and electric feedthroughs also will be coated by the ALD process then. At low pressure, such as for example a pressure of 10⁻² mbar, the means for generating RF radiation may be used to generate and maintain a plasma within the dielectric tube. The latter may be advantageous as it allows plasma enhanced atomic layer deposition. As gas, such as for example precursor gas or reaction gas, passes through the plasma, radicals can be formed thus allowing improved reactivity. The reaction area in the tube is positioned downstream the plasma generation region but adjacent thereto. In one embodiment, the dielectric tube runs through the inductor coil (plasma region) in a first region and the dielectric tube runs through the furnace in a second region, the reaction/deposition region, which is downstream of the plasma region. A lot of electrons and radicals are present in the downstream region of the plasma region, while the density of high energy ions is relatively low, avoiding physical bombardment of the surface. In principle, for a proper choice of the coil material, the coil could also be mounted within the furnace. As set out above, the reaction region often is determined to the region where temperature control can be performed, i.e. where the heating is applied. Plasma-enhanced processes usually allow for a faster deposition speed, and may be performed at lower substrate temperature. Moreover, for porous powders, due to a selectable reduced conformality as compared to thermal ALD, PE-ALD can be used to selectively coat the outside surface of the particles, without coating the interior surface of the pores. The plasma can also be used for surface treatment prior to deposition (e.g. oxidation or nitridation of the surface). By way of illustration, the present invention not being limited thereto, an example of an RF generating means in the form of an RF coil 502 for ICP positioned around the dielectric tube is illustrated in FIG. 5. FIG. 5 also illustrates a sealing means as discussed in the previous embodiment. FIG. 5 furthermore illustrates the use of an internal dielectric tube 504 for loading the powder, which may be positioned in the rotarty dielectric tube and a means for transfer of rotary movement 506 from the outer dielectric tube to the inner dielectric tube. In this way, if the internal dielectric tube is not usable anymore, e.g. because it is contaminated, it can be easily replaced.

In still another particular embodiment, the present invention relates to a system as described in any or a combination of the above embodiments, wherein furthermore a means for providing continuous feeding of objects to be treated or coated is provided. The means for providing continuous feeding may provide objects from a supply zone into the reaction region in the dielectric tube, maintaining the objects in the reaction region for a certain amount of time and automatically removing the objects out of the reaction region thereafter. In one example, the propagation of objects may be obtained by providing indentations in the dielectric tube under an angle with respect to the axis of rotation. Upon rotation, the objects undergo an average longitudinal propagation along the length of the tube. The latter is similar to the principle of an Archimedes' screw for water. The principle is illustrated in FIG. 6. The patterned portions indicate the indentations of the tube wall, allowing for the objects to be propagated. By selecting the angle between the axis of rotation and the main direction of indentations, the propagation speed can be controlled, taking into account the rotation speed for the dielectric tube. Other continuous feeding means may comprise a gas flowing means, providing a continuous flow for displacing the objects at a given speed, a conveyor belt along the length direction of the tube and following the rotation of the tube allowing propagation of objects during moments the conveyor belt is at the lower part of the dielectric tube, etc.

The present invention furthermore relates to a method for performing atomic layer deposition simultaneously on a plurality of three dimensional objects. The method is especially suitable for providing a conformal coating or treatment, e.g. with uniform thickness, to three dimensional objects. The method according to embodiments comprises the steps of providing a plurality of three dimensional objects simultaneously in a dielectric tube under vacuum. The latter may for example be particles, powder or granular material, the invention not being limited thereto. The method further comprises providing a rotation of the dielectric tube, so as to rotate the plurality of three dimensional objects. The latter allows exposing of the whole surface of the three dimensional objects to precursor or reactant gas, thus allowing improved conformity of the process while being able to treat or coat large quantities. The method also comprises providing, during said rotating, precursor materials so as to coat or treat the plurality of objects using atomic layer deposition. The method further may comprise applying an RF signal, so as to provide RF radiation in the dielectric tube. The latter may allow for plasma enhanced atomic layer deposition, resulting in particular applications and improved reactivity. Further features and advantages may be as obtainable with or corresponding with the features of the system described in embodiments of the first aspect.

By way of illustration, embodiments of the present invention not being limited thereby, the results of a number of examples of atomic layer depositions are discussed below, illustrating features and advantages of embodiments according to the present invention.

In a first set of examples, deposition using a rotating atomic layer deposition reactor on stainless steel powder and Titanium powder. The stainless steel powder was 316L stainless steel powder having a diameter in the range 45µm to 125µm. The powder particles all are spherically shaped and have a smooth surface. Some small particles can be seen attached to the larger particles, before any deposition has taken place. The powder comprises iron, chromium and nickel, no aluminium signal could be noticed in the EDX (energy-dispersive x-ray spectroscopy) spectrum. The titanium powder comprises larger particles having a diameter between 0.2mm and 1.5mm. The particles are not spherical, but have a more irregular shape, varying from particle to particle. EDX measurements confirm that before deposition only titanium is detected, no aluminium can be seen.

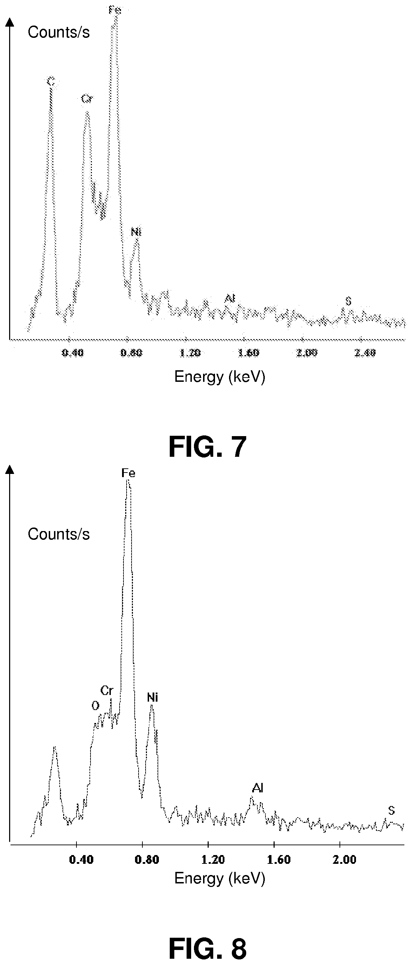

In a first particular example, thermal atomic layer deposition of aluminumoxide Al₂O₃ on stainless steel powder is described. 200 cycles at an environmental temperature of 80°C were performed, whereby each cycle comprised a 5 seconds pulse of TMA followed by a 40 seconds evacuation period, a 5 seconds pulse of H₂O and another 40 seconds evacuation period. The total length of one cycle therefore is 90s. The rotation speed of the system is 36 turns per minute with a diameter of the dielectric tube of about 4cm. After the deposition, it was checked using SEM that no change in morphology of the particles could be seen. From EDX it could be seen that Aluminum and oxygen indeed are present on the particles after deposition while this was absent prior to deposition, which can be seen as confirmation of the deposition of Al₂O₃. The latter is illustrated in FIG. 7 and FIG. 8, whereby FIG. 7 illustrates the EDX spectrum of a particle prior to deposition and FIG. 8 illustrates the EDX spectrum (filled spectrum) after deposition.

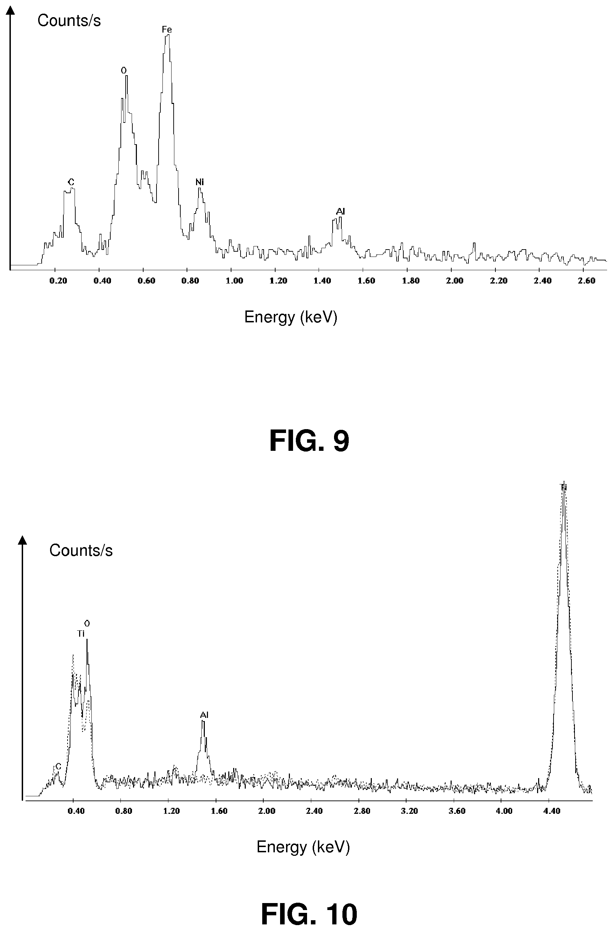

In a second particular example, plasma enhanced deposition of atomic layer deposition on stainless steel powder. Similar conditions are used as in the first particular example, but the 5 seconds H₂O step is replaced by a 5 seconds O₂ plasma pulse at 100W power. Again a check using SEM confirmed that no changes in morphology occurred and EDX confirmed the presence of Aluminum and oxygen on the particles, indicating deposition of Al₂O₃. The EDX spectrum is shown in FIG. 9, expressing the number of counts per second as function of the energy (keV).

In a third particular example, thermal deposition of aluminumoxide Al₂O₃ on titanium powder is described. 200 cycli at an environmental temperature of 80°C were performed, whereby each cycle comprised a 5 seconds pulse of TMA followed by a 30 seconds evacuation period, a 5 seconds pulse of H₂O and another 50 seconds evacuation period. The total length of one cycle therefore is 90s. The rotation speed of the system is 36 turns per minute with a diameter of the dielectric tube of about 4cm. After the deposition, it was confirmed using SEM that no change in morphology of the particles could be seen. From EDX it could be seen that Aluminum and oxygen indeed are present on the particles after deposition while these were absent prior to deposition, which can be seen as confirmation of the deposition of Al₂O₃. The latter is illustrated in FIG. 10, illustrating the EDX spectrum (full line) after deposition and the EDX spectrum (dashed line) prior to deposition.

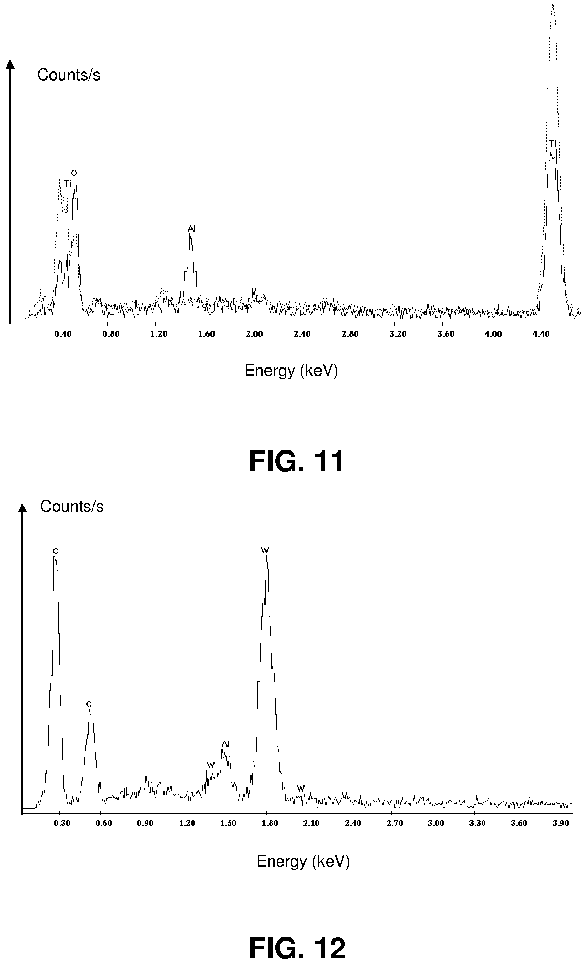

In a fourth particular example, plasma enhanced deposition of aluminium oxide on titanium powder is described. Again 200 cycles at an environmental temperature of 80°C were performed, whereby each cycle comprised a 5 seconds pulse of TMA followed by a 15 seconds evacuation period, a 5 seconds pulse of O₂ plasma pulse at 100W power and another 15 seconds evacuation period. The total length of one cycle therefore is 40s. The rotation speed of the system is 36 turns per minute with a diameter of the dielectric tube of about 4cm. After the deposition, it was confirmed using SEM that no change in morphology of the particles could be seen. From EDX it could be seen that aluminum and oxygen indeed are present on the particles after deposition while these were absent prior to deposition, which can be seen as confirmation of the deposition of Al₂O₃. The latter is illustrated in FIG. 11, illustrating the EDX spectrum (full line) after deposition and the EDX spectrum (dashed line) prior to deposition.

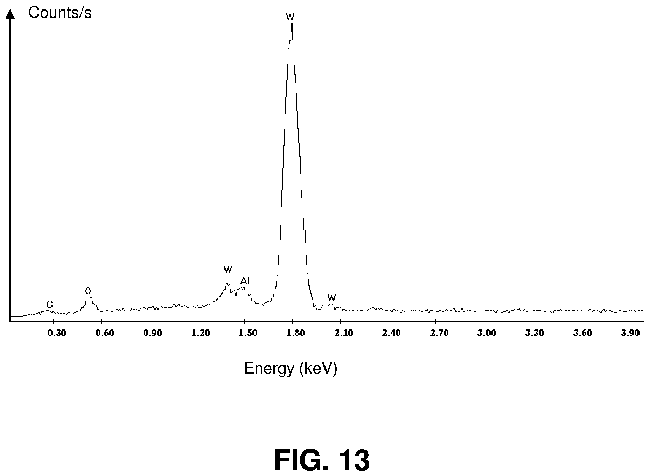

In a second set of particular embodiments, thermal atomical layer deposition of aluminumoxide on Tungsten filaments is discussed. The deposition is performed using 200 cycles at an environmental temperature of 80°C, whereby each cycle comprised a 5 seconds pulse of TMA followed by a 20 seconds evacuation period, a 5 seconds pulse of H₂O and another 20 seconds evacuation period. The total length of one cycle therefore is 50s. The rotation speed of the system is 36 turns per minute with a diameter of the dielectric tube of about 4cm. The filament used was a Tungsten filament having a spiral shape. Before deposition no aluminium signal could be found in EDX spectra of the filaments. Aluminumoxide deposition on the filament could be detected after deposition, both at the inside of the filament as well as at the outside of the filament. A carbon peak also was present because the filament was taped using carbon tape. FIG. 12 illustrates an EDX spectrum recorded at the inside of the first filament, whereas FIG. 13 illustrates an EDX spectrum recorded at the outside of the first filament. It can be seen that after deposition, oxygen and aluminium is present according to the spectrum.

The above examples illustrate amongst others that mass coating of volumetric items can be performed using atomic layer deposition using embodiments according to the present invention.

It is to be understood that although preferred embodiments, specific constructions and configurations, as well as materials, have been discussed herein for devices according to the present invention, various changes or modifications in form and detail may be made without departing from the scope of this invention as defined by the appended claims. Whereas in the present invention a method and system are described for applying atomic layer deposition to a plurality of three-dimensional objects simultaneously, the present invention also relates to three-dimensional objects treated or coated using such a technique. As some embodiments according to the present invention introduce the possibility for plasma enhanced atomic layer deposition on a plurality of three-dimensional objects, thus allowing reduction of the processing temperature or allowing new types of reactions, embodiments of the present invention relate also in particular to three-dimensional objects that have received such a treatment or coating.

## Claims

1. An atomic layer deposition system for providing a coating or treatment to a plurality of three dimensional objects simultaneously, the atomic layer deposition system being a plasma enhanced atomic layer deposition system comprising
- a dielectric tube adapted for containing the plurality of objects under vacuum,
- at least one inlet for providing a gaseous material in the dielectric tube,
- an RF radiation generator adjacent the dielectric tube that enables plasma enhanced deposition or treatment of the plurality of objects, and wherein the system comprises a rotation mechanism for rotating the dielectric tube which is rotatably mounted so as to be able to rotate the plurality of objects under vacuum during atomic layer deposition for providing a coating or treatment on the plurality of objects,
**characterised in that**
the system comprises a second dielectric tube contained within and fixed to the rotatable dielectric tube containing the plurality of objects, and
mechanical indentations in the dielectric tube that cause the plurality of objects to tumble and to be maintained within a reaction area for at least a predetermined amount of time that are furthermore positioned downstream a region of plasma generation, but adjacent thereto.

2. An atomic layer deposition system according to claim 1, wherein the system comprises a controller for controlling the inlet of different gaseous materials in sequence.

3. An atomic layer deposition system according to any of the previous claims, wherein a tube furnace is provided around the rotatable dielectric tube.

4. An atomic layer deposition system according to any of the previous claims, the system comprising a vacuum sealing means for allowing maintenance of a vacuum of 10⁻⁵ mbar, advantageously at least 5.10⁻⁶ mbar, more advantageously 2.10⁻⁶ mbar at a rotation speed of the dielectric tube of at least 1 rpm, advantageously at least 20 rpm, more advantageously at least 50 rpm, the system comprising a static metal flange and a rotatable metal tube, wherein the vacuum sealing means comprises a first seal for providing a vacuum sealing between the rotatable dielectric tube and the rotatable metal tube, and a second seal for providing an oil-based sealing between the rotatable metal tube and the static metal flange.

5. An atomic layer deposition system according to any of the previous claims, wherein the system comprises a feeding means for providing a continuous feed of objects to be coated or treated.

6. An atomic layer deposition system according to claim 5, wherein the feeding means for providing a continuous feed of objects comprises mechanical indentations in the dielectric tube for propagating the plurality of objects through the dielectric tube upon rotation.

7. An atomic layer deposition system according to any of the previous claims, wherein the at least one inlet for providing a precursor material is connected to a vessel containing the precursor.

8. An atomic layer deposition system according to any of the previous claims, wherein the at least one inlet for providing a gaseous material consists of one entrance point for gaseous material to enter the tube, per type of gaseous material.

9. A method for conformal coating or treating of a plurality of three dimensional objects simultaneously, the method comprising
- providing a plurality of three dimensional objects simultaneously in a dielectric tube under vacuum
- rotating the dielectric tube so as to rotate the plurality of three dimensional objects, and
- providing, during said rotating, precursor materials so as to coat or treat the plurality of objects using RF plasma enhanced atomic layer deposition,
**characterised in that**
the providing objects is providing the objects being contained in a second dielectric tube, the electric tube being fixed to the first dielectric tube, and
the method also comprises causing the plurality of objects to tumble using mechanical indentations and maintaining the plurality of objects within a reaction area for at least a predetermined amount of time that are furthermore positioned downstream a region of plasma generation, but adjacent thereto.

10. A method according to claim 9, wherein the method further comprises propagating the plurality of objects through the dielectric tube at a predetermined speed so as to allow continuous feeding of objects.

## Patentansprüche

1. Atomlagenabscheidungssystem zum gleichzeitigen Bereitstellen einer Beschichtung oder Behandlung für eine Vielzahl von dreidimensionalen Objekten, wobei das Atomlagenabscheidungssystem ein plasmaunterstütztes Atomlagenabscheidungssystem ist, umfassend
- ein dielektrisches Rohr, das angepasst ist, die Vielzahl von Objekten unter Vakuum aufzunehmen,
- mindestens einen Einlass zum Bereitstellen eines gasförmigen Materials in dem dielektrischen Rohr,
- einen HF-Strahlungsgenerator neben dem dielektrischen Rohr, der eine plasmaunterstützte Abscheidung oder Behandlung der Vielzahl von Objekten ermöglicht, und wobei das System einen Drehmechanismus zum Drehen des dielektrischen Rohrs umfasst, das drehbar montiert ist, um es zu ermöglichen, die Vielzahl von Objekten unter Vakuum während der Atomlagenabscheidung zu drehen, um eine Beschichtung oder Behandlung der Vielzahl von Objekten bereitzustellen,
**dadurch gekennzeichnet, dass**
das System ein zweites dielektrisches Rohr umfasst, das in dem drehbaren dielektrischen Rohr, das die Vielzahl von Objekten enthält, enthalten ist und daran befestigt ist, und
mechanische Vertiefungen in dem dielektrischen Rohr, die bewirken, dass die Vielzahl von Objekten stürzen und für mindestens eine vorbestimmte Zeitdauer innerhalb eines Reaktionsbereichs gehalten werden, die ferner stromabwärts von einem Bereich der Plasmaerzeugung, jedoch angrenzend daran liegend, positioniert sind.

2. Atomlagenabscheidungssystem nach Anspruch 1, wobei das System eine Steuerung zum Steuern des Einlasses verschiedener gasförmiger Materialien in Folge umfasst.

3. Atomlagenabscheidungssystem nach einem der vorhergehenden Ansprüche, wobei ein Rohrofen um das drehbare dielektrische Rohr herum bereitgestellt ist.

4. Atomschichtabscheidungssystem nach einem der vorhergehenden Ansprüche, wobei das System eine Vakuumabdichtungseinrichtung umfasst, um die Aufrechterhaltung eines Vakuums von 10⁻⁵ mbar, vorteilhafterweise von mindestens 5.10⁻⁶ mbar, noch vorteilhafter 2.10⁻⁶ mbar bei einer Drehgeschwindigkeit des dielektrischen Rohrs von wenigsten 1 U/min, vorteilhafterweise mindestens 20 U/min, noch vorteilhafter 50 U/min zu ermöglichen,
wobei das System einen statischen Metallflansch und ein drehbares Metallrohr umfasst, wobei die Vakuumabdichtungseinrichtung eine erste Dichtung zum Bereitstellen einer Vakuumdichtung zwischen dem drehbaren dielektrischen Rohr und dem drehbaren Metallrohr und eine zweite Dichtung zum Bereitstellen einer Dichtung auf Ölbasis zwischen dem drehbaren Metallrohr und dem statischen Metallflansch umfasst.

5. Atomlagenabscheidungssystem nach einem der vorhergehenden Ansprüche, wobei das System eine Zuführeinrichtung zum Bereitstellen einer kontinuierlichen Zuführung von zu beschichtenden oder zu behandelnden Objekten umfasst.

6. Atomlagenabscheidungssystem nach Anspruch 5, wobei die Zuführeinrichtung zum Bereitstellen einer kontinuierlichen Zuführung von Objekten mechanische Vertiefungen in dem dielektrischen Rohr zum Ausbreiten der Vielzahl von Objekten durch das dielektrische Rohr bei der Drehung umfasst.

7. Atomlagenabscheidungssystem nach einem der vorhergehenden Ansprüche, wobei der mindestens eine Einlass zum Bereitstellen von Vorprodukt-Material mit einem Gefäß verbunden ist, das das Vorprodukt enthält.

8. Atomlagenabscheidungssystem nach einem der vorhergehenden Ansprüche, wobei der mindestens eine Einlass zum Bereitstellen eines gasförmigen Materials aus einem Eintrittspunkt für gasförmiges Material besteht, um je Art von gasförmigem Material in das Rohr einzutreten.

9. Verfahren zum gleichzeitigen konformen Beschichten oder Behandeln einer Vielzahl von dreidimensionalen Objekten, wobei das Verfahren Folgendes umfasst
- Bereitstellen einer Vielzahl von dreidimensionalen Objekten gleichzeitig in einem dielektrischen Rohr unter Vakuum
- Drehen des dielektrischen Rohrs, um die Vielzahl von dreidimensionalen Objekten zu drehen, und
- Bereitstellen, während des Drehens, von Vorprodukt-Materialien, um die Vielzahl von Objekten unter Verwendung einer durch HF-Plasma verstärkten Atomlagenabscheidung zu beschichten oder zu behandeln,
**dadurch gekennzeichnet, dass**
das Bereitstellen von Objekten Objekte bereitstellt, die in einem zweiten dielektrischen Rohr enthalten sind, wobei das elektrische Rohr an dem ersten dielektrischen Rohr befestigt ist, und
das Verfahren auch das Bewirken umfasst, dass die Vielzahl von Objekten unter Verwendung von mechanischen Vertiefungen stürzen und dass die Vielzahl von Objekten für mindestens eine vorbestimmte Zeitdauer innerhalb eines Reaktionsbereichs gehalten werden, die ferner stromabwärts von einem Bereich der Plasmaerzeugung, jedoch angrenzend daran liegend, positioniert sind.

10. Verfahren nach Anspruch 9, wobei das Verfahren ferner das Ausbreiten der Vielzahl von Objekten durch das dielektrische Rohr mit einer vorbestimmten Geschwindigkeit umfasst, um ein kontinuierliches Zuführen von Objekten zu ermöglichen.

## Revendications

1. Système de dépôt en couche atomique pour fournir un revêtement ou traitement à une pluralité d'objets tridimensionnels simultanément, le système de dépôt en couche atomique étant un système de dépôt en couche atomique amélioré par plasma comprenant
- un tube diélectrique adapté pour contenir la pluralité d'objets sous vide,
- au moins une entrée pour fournir un matériau gazeux dans le tube diélectrique,
- un générateur de rayonnement RF adjacent au tube diélectrique qui permet un dépôt ou traitement amélioré par plasma de la pluralité d'objets, et dans lequel le système comprend un mécanisme de rotation pour faire tourner le tube diélectrique qui est monté de manière rotative de façon à pouvoir faire tourner la pluralité d'objets sous vide durant un dépôt en couche atomique pour fournir un revêtement ou traitement sur la pluralité d'objets,
**caractérisé en ce que**
le système comprend un deuxième tube diélectrique contenu dans et fixé au tube diélectrique rotatif contenant la pluralité d'objets, et
des encoches mécaniques dans le tube diélectrique qui amènent la pluralité d'objets à tourbillonner et à être maintenus dans une zone de réaction pendant au moins une quantité de temps prédéterminée qui sont en outre positionnées en aval d'une région de génération de plasma, mais adjacentes à celle-ci.

2. Système de dépôt en couche atomique selon la revendication 1, dans lequel le système comprend un dispositif de commande pour commander l'entrée de différents matériaux gazeux de manière séquentielle.

3. Système de dépôt en couche atomique selon l'une quelconque des revendications précédentes, dans lequel un four à tube est fourni autour du tube diélectrique rotatif.

4. Système de dépôt en couche atomique selon l'une quelconque des revendications précédentes, le système comprenant un moyen d'étanchéité sous vide pour permettre le maintien d'un vide de 10⁻⁵ mbar, avantageusement d'au moins 5,10⁻⁶ mbar, plus avantageusement d'au moins 2,10⁻⁶ mbar à une vitesse de rotation du tube diélectrique d'au moins 1 rpm, avantageusement d'au moins 20 rpm, plus avantageusement d'au moins 50 rpm, le système comprenant une bride métallique statique et un tube métallique rotatif, dans lequel le moyen d'étanchéité sous vide comprend un premier joint pour fournir une étanchéité sous vide entre le tube diélectrique rotatif et le tube métallique rotatif, et un second joint pour fournir une étanchéité à base d'huile entre le tube métallique rotatif et la bride métallique statique.

5. Système de dépôt en couche atomique selon l'une quelconque des revendications précédentes, dans lequel le système comprend un moyen d'alimentation pour fournir une alimentation continue d'objets à revêtir ou traiter.

6. Système de dépôt en couche atomique selon la revendication 5, dans lequel le moyen d'alimentation pour fournir une alimentation continue d'objets comprend des encoches mécaniques dans le tube diélectrique pour propager la pluralité d'objets à travers le tube diélectrique lors de la rotation.

7. Système de dépôt en couche atomique selon l'une quelconque des revendications précédentes, dans lequel l'au moins une entrée pour fournir un matériau précurseur est connectée à une cuve contenant le précurseur.

8. Système de dépôt en couche atomique selon l'une quelconque des revendications précédentes, dans lequel l'au moins une entrée pour fournir un matériau gazeux est constituée d'un point d'entrée pour faire entrer le matériau gazeux dans le tube, par type de matériau gazeux.

9. Procédé de revêtement enrobant ou de traitement d'une pluralité d'objets tridimensionnels, le procédé comprenant
- la fourniture d'une pluralité d'objets tridimensionnels simultanément dans un tube diélectrique sous vide
- la mise en rotation du tube diélectrique de manière à faire tourner la pluralité d'objets tridimensionnels, et
- la fourniture, durant ladite rotation, de matériaux précurseurs de manière à revêtir ou traiter la pluralité d'objets à l'aide d'un dépôt en couche atomique amélioré par plasma RF, **caractérisé en ce que** la fourniture d'objets fournit les objets contenus dans un second tube diélectrique, le tube électrique étant fixé au premier tube diélectrique, et le procédé comprenant également le fait d'amener la pluralité d'objets à tourbillonner à l'aide d'encoches mécaniques et de maintenir la pluralité d'objets dans une zone de réaction pendant au moins une quantité de temps prédéterminée qui sont en outre positionnés en aval d'une région de génération de plasma, mais adjacentes à celle-ci.

10. Procédé selon la revendication 9, dans lequel le procédé comprend en outre la propagation de la pluralité d'objets à travers le tube diélectrique à une vitesse prédéterminée de manière à permettre une alimentation continue d'objets.
